(19) Europäisches Patentamt / European Patent Office / Office européen des brevets

(11) **EP 3 627 526 B1**

(12) **FASCICULE DE BREVET EUROPEEN**

(45) Date de publication et mention
de la délivrance du brevet:
**26.07.2023 Bulletin 2023/30**

(21) Numéro de dépôt: **19197934.3**

(22) Date de dépôt: **18.09.2019**

(51) Classification Internationale des Brevets (IPC):
*H01G 4/33* *(2006.01)* *H01L 21/00* *(2006.01)*
*H01G 4/005* *(2006.01)*

(52) Classification Coopérative des Brevets (CPC):
**H01G 4/33; H01L 28/40;** H01G 4/005

(54) **CONDENSATEUR**

KONDENSATOR

CAPACITOR

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **21.09.2018 FR 1858585**

(43) Date de publication de la demande:
**25.03.2020 Bulletin 2020/13**

(60) Demande divisionnaire:
**23167146.2**

(73) Titulaire: **STMicroelectronics (Tours) SAS
37100 Tours (FR)**

(72) Inventeur: **BOUFNICHEL, Mohamed
37380 MONNAIE (FR)**

(74) Mandataire: **Cabinet Beaumont
4, Place Robert Schuman
B.P. 1529
38025 Grenoble Cedex 1 (FR)**

(56) Documents cités:
**EP-A2- 2 878 002          EP-B1- 2 878 002
WO-A1-2015/047233      CN-A- 107 689 362
US-A1- 2008 186 648    US-A1- 2009 079 029
US-A1- 2015 076 657**

**Description**

Domaine technique

La présente description concerne de façon générale des composants électroniques et plus particulièrement des condensateurs.

Technique antérieure

Les condensateurs sont des composants très présents dans les circuits électroniques. Les condensateurs sont des composants électroniques, comprenant généralement deux électrodes séparées par une couche isolante.

Dans le cadre de la miniaturisation des composants électroniques, on cherche aujourd'hui à augmenter la capacité obtenue pour une surface de substrat donnée.

Le document CN 107 689 362 décrit un système de stockage semiconducteur et un procédé de formation de contour de condensateur associé.

Résumé de l'invention

L'invention est définie par la revendication 1. Divers modes de réalisation sont définis par les revendications 2 à 13.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, schématiquement et partiellement, deux modes de réalisation d'un condensateur ;

la figure 2 représente, en vue de dessus, des exemples d'une partie des structures de la figure 1 ;

la figure 3 représente, schématiquement et partiellement, deux structures résultant d'étapes d'un mode de réalisation d'un procédé de fabrication d'un condensateur ;

la figure 4 représente, schématiquement et partiellement, deux structures résultant d'autres étapes d'un mode de réalisation d'un procédé de fabrication d'un condensateur ;

la figure 5 représente, schématiquement et partiellement, une structure résultant d'une étape d'un mode de réalisation d'un procédé de fabrication d'un condensateur ; et

la figure 6 représente schématiquement et partiellement, un autre exemple d'un condensateur obtenu par la mise en oeuvre du procédé des figures 3 à 5.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence, sauf précision contraire, à l'orientation des figures.

Sauf précision contraire, les expressions "environ", "approximativement", "sensiblement", et "de l'ordre de" signifient à 10 % près, de préférence à 5 % près.

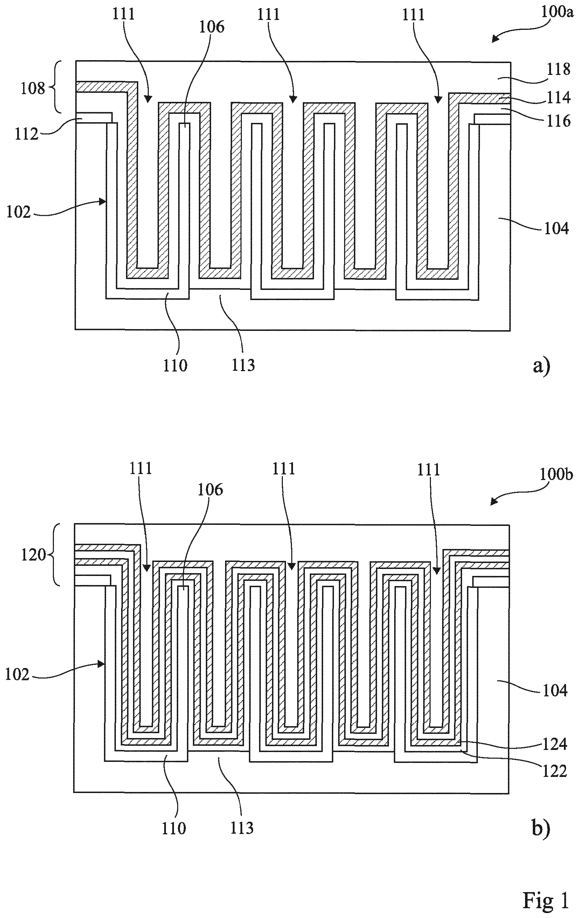

La figure 1 comprend deux vues en coupe, a) et b), représentant, schématiquement et partiellement, deux modes de réalisation d'un condensateur 100a ou 100b, par exemple situé dans une cavité 102 d'un substrat 104.

Les condensateurs 100a et 100b sont des condensateurs verticaux, c'est-à-dire des condensateurs comprenant un empilement de couches s'étendant au moins partiellement dans une direction sensiblement verticale. Par une direction sensiblement verticale, on entend une direction formant un angle de moins de 45 ° avec la direction verticale.

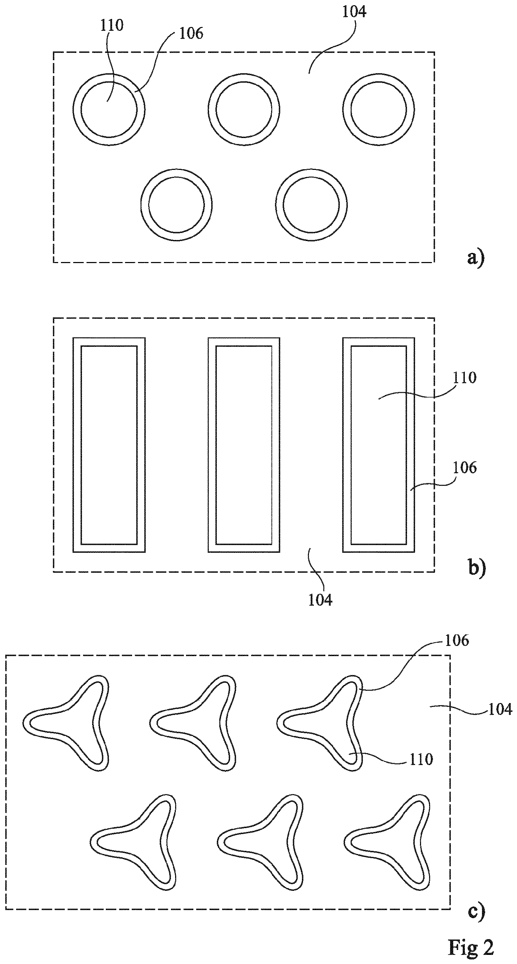

La vue a) illustre un condensateur 100a. Des murs 106 sont situés dans la cavité 102 et s'étendent à partir du fond de la cavité 102. Les murs 106 atteignent par exemple l'ouverture de la cavité 102. Les murs 106 forment les contours de formes géométriques, dont des exemples seront décrits en relation avec la figure 2. Les contours formés par les murs sont de préférence des contours fermés. Les régions du fond de la cavité 102 situées à l'intérieur des contours de chaque mur 106 sont de préférence recouvertes d'une portion 110 du matériau du mur 106. Ainsi, chaque mur 106 et la portion 110 correspondante forment un compartiment 111 comprenant un fond et des parois latérales.

Les régions 113 du substrat 104 situées entre les compartiments 111 ne sont de préférence pas recouvertes d'une couche isolante.

Une partie de certains murs 106 peut être en contact avec les parois de la cavité 102. De plus, des couches 108, par exemple en un matériau isolant, par exemple en le même matériau que les murs 106, sont situées sur la face supérieure du substrat 104 autour de la cavité 102.

Les murs 106 ont de préférence une épaisseur inférieure à 150 nm, par exemple inférieure à 100 nm, par exemple inférieure à 50 nm. De préférence, la face supérieure de chaque portion 110 est coplanaire avec le fond de la cavité 102 hors des contours formés par les murs 106.

Un empilement 108 de couches, constituant le condensateur 100a est déposé sur et entre les murs 106. Plus précisément, l'empilement 108 comprend des couches s'étendant de manière continue dans les compartiments 111, recouvrant les parois internes des murs 106 et les portions 110, et entre les compartiments 111, recouvrant les faces supérieures et les parois externes des murs 106 et les parties du substrat 104 situées entre les compartiments 111.

L'empilement 108, constituant le condensateur 100a, comprend une couche isolante 114 (hachurée en figure 1), entre deux couches conductrices 116 et 118 formant des électrodes. La couche conductrice 116 est la couche inférieure de l'empilement 108 et s'étend de manière conforme sur et entre les murs 106. La couche isolante 114 s'étend de manière conforme sur la couche 114. La couche 118 repose sur la couche isolante 116. La face supérieure de la couche 118 est de préférence sensiblement plane et situé au-dessus de la cavité 102.

L'empilement peut en outre s'étendre hors de la cavité 102. Plus précisément, l'empilement peut s'étendre sur au moins une partie des couches 112, hors de la cavité 102. Des contacts avec les couches conductrices 116 et 118, non représentés, sont par exemple situés hors de la cavité 102.

La vue b) illustre un condensateur 100b, comprenant une pluralité de condensateurs connectés en parallèle. La vue b) est similaire à la vue a) à l'exception de l'empilement de couches 108, qui est remplacé par un empilement de couches 120. L'empilement 120 comprend une alternance de couches conductrices 122 et de couches isolantes 124 (hachurées en figure 1). L'empilement 120 représenté en figure 1 comprend trois couches conductrices 122 et deux couches isolantes 124. L'empilement 120 peut cependant comprendre un nombre quelconque de couches isolantes 124, chacune située entre deux couches conductrices 122. La couche inférieure de l'empilement 120, c'est-à-dire la couche en contact avec les murs 106 et le substrat 104 entre les compartiments 111, est une couche conductrice 122. La couche supérieure de l'empilement 120 est une couche conductrice 122. La face supérieure de la couche supérieure de l'empilement 120 est de préférence sensiblement plane.

Des contacts avec chacune des couches conductrices 122, non représentés, sont par exemple situés hors de la cavité 102.

La figure 2 représente, en vue de dessus, des exemples d'une partie des modes de réalisation de la figure 1. Plus précisément, la figure 2 représente, en vue de dessus, trois exemples de structures a), b) et c) sur lesquelles les condensateurs 100a et 100b peuvent être formés. Ainsi, les vues des structures a), b) et c) correspondent à des vues de la cavité 102 sans les empilements 108 ou 120.

Le contour, de préférence fermé, formé par chaque mur 106 peut être sensiblement celui d'une forme quelconque, par exemple d'un cercle (structure a)), d'un rectangle (structure b)), d'un tripode (structure c)) d'un ovale, etc.

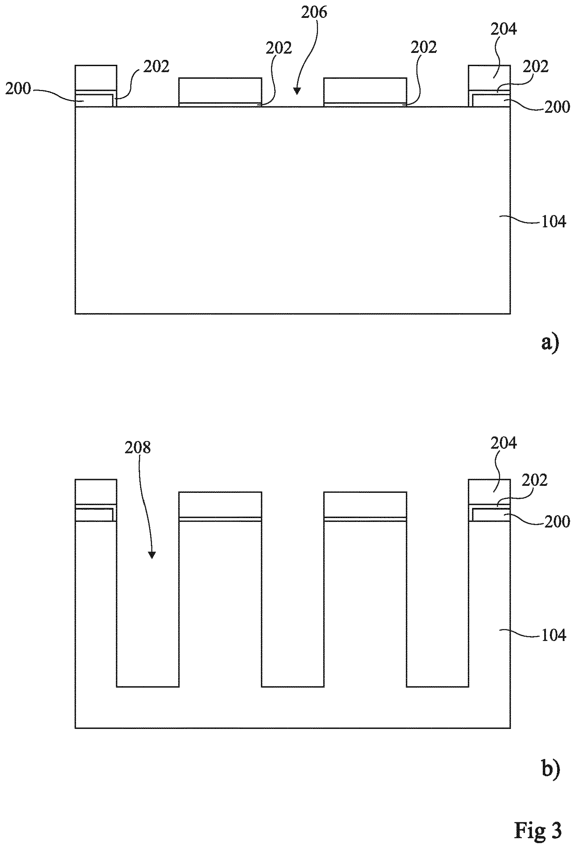

La figure 3 représente, schématiquement et partiellement, deux structures a) et b) résultant d'étapes d'un mode de réalisation d'un procédé de fabrication d'un condensateur.

La structure a) résulte d'une étape de formation d'une couche 200, par exemple en un matériau isolant, par exemple en oxyde de silicium, sur le substrat 104. Le substrat 104 est de préférence en un matériau pouvant être oxydé, par exemple en silicium.

La couche 200 comprend une ouverture à l'emplacement où l'on souhaite former la cavité 102, c'est-à-dire à l'emplacement du condensateur que l'on souhaite former.

Une couche 202 est ensuite formée sur la couche 200 et sur le substrat 104 dans l'ouverture de la couche 200. En particulier, la couche 202 recouvre les parois latérales de la couche 200, c'est-à-dire les parois de l'ouverture. La couche 202 est recouverte d'une couche 204. La couche 204 est de préférence en un matériau isolant, de préférence en le même matériau que la couche 200, par exemple en oxyde de silicium. La couche 202 est en un matériau pouvant être gravé sélectivement par rapport au matériau de la couche 204 et ne pouvant être oxydé, par exemple en nitrure de silicium. Des ouvertures sont ensuite formées dans les couches 202 et 204 aux emplacements des compartiments formés par les murs 106. Plus précisément, les ouvertures 206 dans la couche 202 ont la forme des formes géométriques dont le contour est tracé par les murs 106.

De préférence, les ouvertures dans les couches 202 et 204 sont formées de manière à conserver des portions de la couche 202 sur les parois de la couche 200. Ainsi, la couche 200 est entièrement protégée par la couche 202.

La structure b) résulte d'une étape de gravure au cours de laquelle le substrat est gravé à travers les ouvertures 206 de manière à former des cavités 208.

Les ouvertures des cavités ont par exemple des dimensions critiques comprises entre environ 0,5 $\mu$m et

environ 1 $\mu$m et une profondeur comprise entre 35 et 45 $\mu$m.

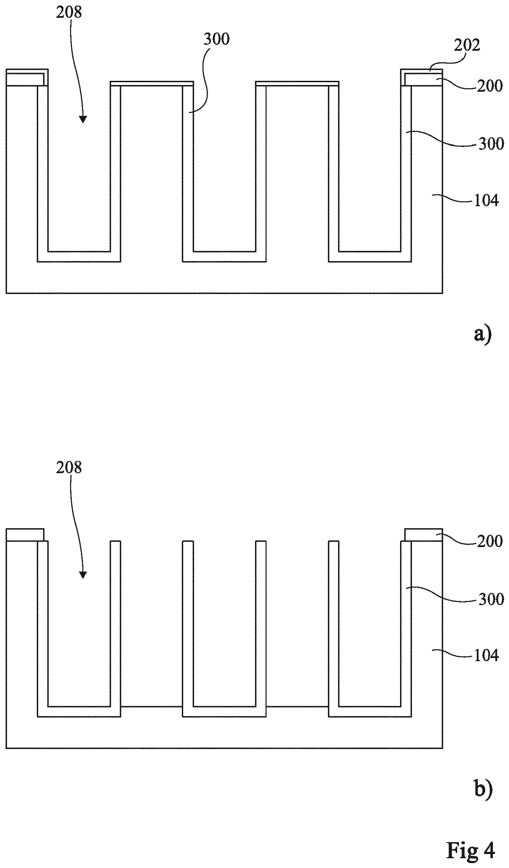

La figure 4 représente, schématiquement et partiellement, deux structures a) et b) résultant d'autres étapes d'un mode de réalisation d'un procédé de fabrication d'un condensateur.

La structure a) résulte d'une étape au cours de laquelle la couche 204 est retirée et au cours de laquelle une couche isolante 300 est formée sur les parois et le fond de chaque cavité 208. Les couches 300 sont par exemple formées en oxydant le matériau du substrat 104 au niveau des parois et du fond des cavités 208. Chaque couche 300 comprend une première portion située sur le fond de la cavité, et des deuxièmes portions s'étendant sur les parois de la cavité, entre le fond de la cavité et son ouverture. Les deuxièmes portions constitueront les murs 106 et les premières portions constitueront les portions 110.

L'épaisseur de la couche 300, et donc des murs 106, est de préférence inférieure à 150 nm, par exemple inférieure à 100 nm, par exemple inférieure à 50 nm.

La structure b) est obtenue après une étape de retrait de la couche 202 et une étape de gravure du substrat 104 situé entre les deuxièmes portions des couches 300. La gravure du substrat est par exemple maintenue jusqu'à atteindre le même niveau que la face supérieure du fond des cavités 208.

Le procédé de gravure du substrat 104 est choisi de manière à ne pas graver le matériau des couches 300 et 200. Les couches 200 permettent ainsi de protéger les parties du substrat 104 que l'on ne cherche pas à graver.

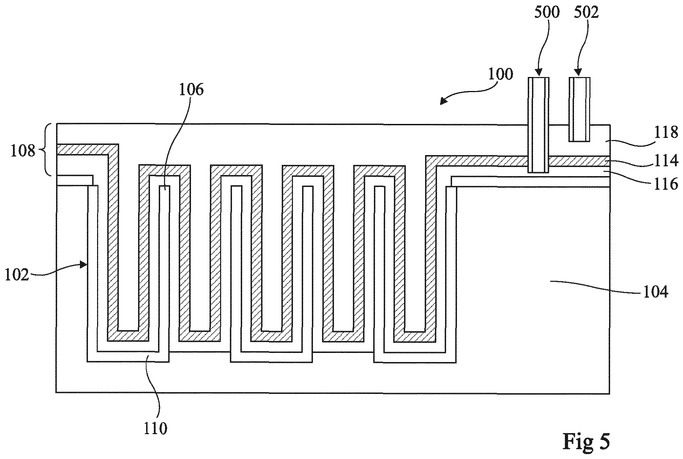

La figure 5 représente, schématiquement et partiellement, une structure résultant d'une autre étape d'un mode de réalisation d'un procédé de fabrication d'un condensateur.

Au cours de cette étape, l'empilement de couches 108 ou 120 formant le condensateur est formé. L'empilement représenté en figure 5 est l'empilement 108, comprenant une couche isolante 114 entre deux couches conductrices 116 et 118.

Les contacts avec les différentes couches conductrices sont ensuite formés. Il s'agit par exemple de vias isolés 500 et 502, comprenant un coeur conducteur entouré d'une gaine isolante. Le via isolé 502 permet la connexion électrique avec la couche conductrice 118. Le via isolé 500 traverse la couche conductrice 118 et la couche isolante 114 et permet la connexion électrique avec la couche conductrice 116.

Un avantage des modes de réalisation décrits est qu'ils permettent d'augmenter la capacité d'un condensateur sur une surface de substrat donné.

On aurait pu former des condensateurs en gravant des cavités dans le substrat et en formant l'empilement de couches constituant le condensateur dans les cavités et sur les parties (non gravées) du substrat situées entre les cavités, ces parties du substrat ayant alors une utilisation similaire à celle des murs 106. Cependant, les procédés de gravure actuels, par exemple les procédés de photolithographie, ne permettent pas de former des cavités profondes et étroites, c'est-à-dire ayant par exemple une profondeur supérieure à 20 $\mu$m, par exemple égale à 40 $\mu$m, et ayant par exemple des dimensions horizontales inférieures à 1 $\mu$m, séparées par des fines portions de substrat d'épaisseur, par exemple inférieure à 1 $\mu$m.

La capacité d'un condensateur comprenant une couche isolante entre deux couches conductrices est définie par l'équation suivante :

$$[Math\ 1]$$

$$C = \frac{\epsilon_r \varepsilon_0 A}{d}$$

où d est l'épaisseur de la couche isolante, A est l'aire de l'interface entre la couche isolante et l'une des couches conductrices, $\varepsilon_0$ est la permittivité du vide et $\varepsilon_r$ est la permittivité relative du matériau de la couche isolante.

Ainsi, la diminution de l'épaisseur des murs permet d'augmenter l'aire A pour une surface de substrat donnée et donc la capacité du condensateur.

Il est possible de modifier différents critères de manière à obtenir des condensateurs adaptés aux diverses applications possibles. Ainsi, il est par exemple possible de modifier :

- la profondeur des cavités 102, et donc des cavités 208 ;
- le nombre de couches dans l'empilement 108 ou 120, et donc le nombre de condensateurs en parallèle ;
- le nombre de cavités 208 ; et
- les dimensions des ouvertures des cavités 208.

Par exemple, pour une surface de substrat donnée, il est possible de diminuer la profondeur du condensateur tout en conservant sensiblement la même valeur de capacité que dans le cas où les cavités sont séparées par des murs faits à partir du substrat 104.

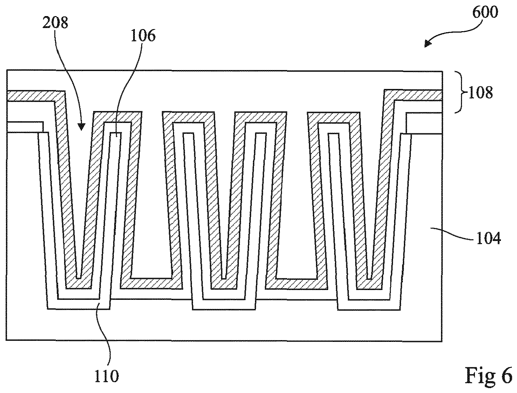

La figure 6 représente, schématiquement et partiellement, un autre exemple d'un condensateur obtenu par la mise en oeuvre du procédé des figures 3 à 5.

Dans ce mode de réalisation, les parois latérales de chaque mur 106 sont inclinées par rapport à la direction verticale, d'un angle inférieur à 45 °, par exemple de telle manière que la distance entre les parois près de la portion 110 est inférieure à la distance entre les faces supérieures des parois latérales du mur.

La forme penchée des murs peut par exemple être obtenue accidentellement lors du procédé de fabrication. Plus particulièrement, une telle forme peut être le résultat de l'étape de gravure des cavités 208 dans laquelle les parois de la cavité 208 obtenue ne sont pas droites.

Dans une structure où les cavités sont séparées par des régions de substrat, une telle forme de murs penchés entraînerait une diminution de la surface A du condensateur et donc une diminution de la capacité par rapport à la capacité que l'on aurait obtenue si les murs n'était pas penchés.

Dans le mode de réalisation de la figure 6, la diminution de la surface entraînée par la forme des cavités 208 est sensiblement compensée par les régions entre les cavités 208. Ces régions ont une forme complémentaire à la forme des cavités 208. Ainsi, la diminution de la surface A dans les cavités 208 est sensiblement compensée par l'augmentation de surface A entre les cavités 208.

Enfin, la mise en oeuvre pratique des modes de réalisation et variantes décrits est à la portée de l'homme du métier à partir des indications fonctionnelles données cidessus.

## Revendications

1. Procédé de fabrication d'un condensateur (100a, 100b) comprenant une étape de formation de murs (106), un empilement de couches (108, 120) s'étendant sur des parois latérales et une face supérieure des murs (106) et entre les murs (106), les murs étant en un premier matériau, les murs s'étendant à partir d'un substrat en un deuxième matériau, les premier et deuxième matériaux étant différents, dans lequel l'empilement de couches (108, 120) s'étend en outre sur le substrat entre les murs (106), le procédé comprenant une étape de formation de cavités (208) dans le substrat (104), et comprenant en outre une étape de gravure des portions de substrat (104) situées entre les cavités (208).

2. Procédé selon la revendication 1, comprenant une étape de formation des murs (106) dans laquelle une couche isolante (300) est formée sur les parois et les fonds de chaque cavité (208) .

3. Procédé selon la revendication 2, dans lequel les couches isolantes (300) sont formées par oxydation sur le substrat (104) .

4. Condensateur vertical (100a, 100b) obtenu par un procédé selon l'une quelconque des revendications 1 à 3.

5. Condensateur (100a, 100b) selon la revendication 4, dans lequel le premier matériau est de l'oxyde de silicium.

6. Condensateur (100a, 100b) selon la revendication 4 ou 5, dans lequel l'empilement (108, 120) comprend une alternance de couches isolantes et de couches conductrices, les couches inférieure (116) et supérieure (118) de l'empilement étant des couches conductrices.

7. Condensateur (100a, 100b) selon l'une quelconque des revendications 4 à 6, dans lequel chaque mur (106) forme, en vue de dessus, le contour d'une forme géométrique.

8. Condensateur (100a, 100b) selon la revendication 7, dans lequel l'empilement s'étend à l'intérieur et à l'extérieur des contours des formes géométriques.

9. Condensateur (100a, 100b) selon la revendication 7 ou 8, dans lequel le substrat à l'intérieur du contour est recouvert d'une couche en le premier matériau.

10. Condensateur (100a, 100b) selon l'une quelconque des revendications 4 à 9, dans lequel l'empilement s'étend sur deux parois opposées d'au moins une partie des murs (106).

11. Condensateur (100a, 100b) selon l'une quelconque des revendications 4 à 10, dans lequel l'épaisseur de chaque mur (106) est inférieure à 150 nm.

12. Condensateur (100a, 100b) selon l'une quelconque des revendications 4 à 11, dans lequel le deuxième matériau est un matériau pouvant être oxydé.

## Patentansprüche

1. Verfahren zum Herstellen eines Kondensators (100a, 100b), das Folgendes aufweist: einen Schritt des Ausbildens von Wänden (106), eines Stapels von Schichten (108, 120), die sich über Seitenwände und eine Oberfläche der Wände (106) und zwischen den Wänden (106) erstrecken, wobei die Wände aus einem ersten Material hergestellt sind, wobei sich die Wände von einem Substrat erstrecken, das aus einem zweiten Material hergestellt ist, wobei sich das erste und das zweite Material unterscheiden, wobei sich der Stapel von Schichten (108, 120) zwischen den Wänden (106) ferner über das Substrat erstreckt, wobei das Verfahren einen Schritt des Ausbildens von Hohlräumen (208) in dem Substrat (104) und einen Schritt des Ätzens der Substratabschnitte (104), die sich zwischen den Hohlräumen (208) liegen, aufweist.

2. Verfahren nach Anspruch 1, aufweisend einen Schritt des Ausbildens von Wänden (106), bei dem eine Isolierschicht (300) auf den Seitenwänden und den Böden jedes Hohlraums (208) gebildet wird.

3. Verfahren nach Anspruch 2, wobei die Isolierschichten (300) durch Oxidation auf dem Substrat (104) gebildet werden.

**4.** Vertikaler Kondensator (100a, 100b), hergestellt nach einem Verfahren nach einem der Ansprüche 1 bis 3.

**5.** Kondensator (100a, 100b) nach Anspruch 4, wobei das erste Material Siliziumoxid ist.

**6.** Kondensator (100a, 100b) nach Anspruch 4 oder 5, wobei der Stapel (108, 120) eine Wechselfolge von isolierenden Schichten und leitenden Schichten aufweist, wobei die unteren (116) und oberen (118) Schichten des Stapels leitende Schichten sind.

**7.** Kondensator (100a, 100b) nach einem der Ansprüche 4 bis 6, wobei jede Wand (106) in der Draufsicht die Kontur einer geometrischen Form bildet.

**8.** Kondensator (100a, 100b) nach Anspruch 7, wobei sich der Stapel innerhalb und außerhalb der Konturen der geometrischen Formen erstreckt.

**9.** Kondensator (100a, 100b) nach Anspruch 7 oder 8, wobei das Substrat innerhalb der Kontur mit einer Schicht aus dem ersten Material bedeckt ist.

**10.** Kondensator (100a, 100b) nach einem der Ansprüche 4 bis 9, wobei sich der Stapel über zwei gegenüberliegende Seiten von mindestens einem Teil der Wände (106) erstreckt.

**11.** Kondensator (100a, 100b) nach einem der Ansprüche 4 bis 10, wobei die kleinste Abmessung jeder Wand (106) kleiner als 150 nm ist.

**12.** Kondensator (100a, 100b) nach einem der Ansprüche 4 bis 11, wobei das zweite Material ein Material ist, das oxidiert werden kann.

## Claims

**1.** A method of manufacturing a capacitor (100a, 100b) comprising a step of forming walls (106), a stack of layers (108, 120) extending over lateral walls and an upper surface of the walls (106) and between the walls (106), the walls being made of a first material, the walls extending from a substrate made of a second material, the first and second materials being different wherein the stack of layers (108, 120) further extends over the substrate between the walls (106), the method comprising a step of forming cavities (208) in the substrate (104) and comprising a step of etching the substrate portions (104) located between the cavities (208).

**2.** The method of claim 1, comprising a step of forming walls (106) wherein an insulating layer (300) is formed on the sidewalls and the bottoms of each cavity (208).

**3.** The method of claim 2, wherein the insulating layers (300) are formed by oxidation on the substrate (104).

**4.** A vertical capacitor (100a, 100b) obtained by a method of any of claim 1 to 3.

**5.** The capacitor (100a, 100b) of claim 4, wherein the first material is silicon oxide.

**6.** The capacitor (100a, 100b) of claim 4 or 5, wherein the stack (108, 120) comprises an alternation of insulating layers and of conductive layers, the lower (116) and upper (118) layers of the stack being conductive layers.

**7.** The capacitor (100a, 100b) of any of claims 4 to 6, wherein each wall (106) forms, in top view, the contour of a geometric shape.

**8.** The capacitor (100a, 100b) of claim 7, wherein the stack extends inside and outside of the contours of the geometric shapes.

**9.** The capacitor (100a, 100b) of claim 7 or 8, wherein the substrate within the contour is covered with a layer made of the first material.

**10.** The capacitor (100a, 100b) of any of claims 4 to 9, wherein the stack extends over two opposite sides of at least a portion of the walls (106).

**11.** The capacitor (100a, 100b) of any of claims 4 to 10, wherein the smallest dimension of each wall (106) is smaller than 150 nm.

**12.** The capacitor (100a, 100b) of any of claims 4 to 11, wherein the second material is a material capable of being oxidized.

Fig 1

Fig 2

Fig 3

a)

b)

Fig 4

Fig 5

Fig 6

**EP 3 627 526 B1**

## RÉFÉRENCES CITÉES DANS LA DESCRIPTION

**Documents brevets cités dans la description**

- CN 107689362